# EUROPEAN PATENT APPLICATION

(11) **EP 4 719 002 A2**
(43) Date of publication of application: **01.04.2026**
(21) Application number: 25205253.5
(22) Date of filing: 29.09.2025
(51) Int. Cl.: H10F 30/225, H10F 39/10, H10F 77/14, H10F 77/40, H10F 77/70

(54) **SINGLE PHOTON AVALANCHE DIODE UNIT AND ELECTRONIC DEVICE**

(30) Priority: 29.09.2024 CN 202411376444
(71) Applicant: Suteng Innovation Technology Co., Ltd, Shenzhen City Guangdong 518000 (CN)
(72) Inventor: ZHANG, Bingpo, Shenzhen City (CN); XIA, Chunqiu, Shenzhen City (CN); WEI, Yan, Shenzhen City (CN); CHAO, Enfei, Shenzhen City (CN); YAO, Guofeng, Shenzhen City (CN)
(74) Representative: Ran, Handong

(57) **Abstract**

The application relates to the field of semiconductors, and particularly relates to a single-photon avalanche diode unit (20) and an electronic equipment. The single-photon avalanche diode unit includes at least one main junction (210) and a barrier region (211), wherein: a size of the main junction is smaller than a preset size; a polarity of the barrier region is the same as that of a first well region (2101), and the first well region is a well region of the main junction away from an electrode (207) of the single-photon avalanche diode unit in a depth direction; the barrier region is in the same layer as the first well region in the depth direction and is arranged around the first well region; and the barrier region extends outward to a hole conducting region (203) of the single-photon avalanche diode unit, and a polarity of the hole conducting region is the same as that of the first well region. The technical scheme can achieve high PDE while ensuring low DCR, thereby improving detection performance of the single-photon avalanche diode unit.

## Description

### TECHNICAL FIELD

The present application relates to the field of semiconductors, and in particular to a single photon avalanche diode unit and an electronic device.

### BACKGROUND

The single photon avalanche diode (SPAD) unit is an avalanche diode working in a Geiger mode, can realize light absorption and conversion of light intensity as low as a single photon level and output of an electric pulse signal, has extremely high detection sensitivity, and can be applied to the fields of imaging, medical treatment, high-energy physics, ion physics research, quantum communication, and laser radar ranging.

Photon detection efficiency (PDE) and dark count rate (DCR) are two important technical indexes for measuring the SPAD. The higher the PDE is, the stronger the detection capability of the SPAD on weak light is; the higher the DCR is, the greater the noise is, and the detection capability of the device is deteriorated. Generally, the area ratio of a main junction in the SPAD to the SPAD is increased to reduce the leakage current of the main junction periphery, so as to improve the collection and detection efficiency of photo-generated carriers. Due to the limitation of process capability, a larger main junction area brings more process defects, which causes significant deterioration of the DCR and a post-pulse index. A larger main junction also causes an increase in a lateral electric field of the main junction periphery and a decrease in a lateral breakdown voltage, resulting in edge breakdown of the main junction and further deterioration of the DCR. Therefore, the design of the SPAD needs to balance the PDE and the DCR, and the optimization of the PDE and the DCR cannot be realized simultaneously.

### SUMMARY

The present application provides a single photon avalanche diode (SPAD) unit, which realizes high photon detection efficiency (PDE) while ensuring low DCR, thereby improving the detection performance of the SPAD unit.

In a first aspect, the present application provides a single photon avalanche diode unit, including at least one main junction and a barrier region, wherein:
a size of the main junction is smaller than a preset size;
the barrier region has the same polarity as that of a first well region, the first well region being a well region in the main junction that is away from an electrode of the single photon avalanche diode unit in a depth direction;
the barrier region is arranged on the same layer as the first well region in the depth direction and surrounds the first well region, and the barrier region extends outward to a hole conducting region of the single photon avalanche diode unit, the hole conducting region having the same polarity as that of the first well region.

In the technical solution, the single-photon avalanche diode unit includes at least one main junction and a barrier region. The size of the main junction is smaller than a preset size. The polarity of the barrier region is the same as that of a first well region in the main junction away from an electrode of the single-photon avalanche diode unit in the depth direction. The barrier region is arranged at the same layer as the first well region in the depth direction and surrounds the first well region, and the barrier region extends outward to a hole conducting region of the single-photon avalanche diode unit with the same polarity as the first well region. By limiting the size of the main junction in the single-photon avalanche diode unit to a smaller size, the number of process defects can be reduced, thereby reducing the DCR. The size of the main junction in the single-photon avalanche diode unit is limited to a smaller size range, the peripheral lateral electric field of the main junction is weakened, the lateral breakdown voltage is increased, the main junction edge breakdown is avoided, and the DCR is further reduced. By arranging the barrier region around the first well region. The barrier region surrounds the first well region and extends outward to the hole conducting region with the same polarity as the first well region, the barrier region can prevent electron photo-generated carriers from flowing to the side, which helps increase the collection efficiency of the photo-generated carriers, and improves the PDE. The barrier region is combined with the main junction with the smaller size to form an electric field convergence effect in the main junction region, thereby the electric field strength near the main junction can be enhanced, the avalanche triggering probability is improved. Therefore, the PDE is further improved; therefore, the PDE and the DCR can be simultaneously optimized, and the detection performance of the single-photon avalanche diode unit is improved.

In an exemplary design, in combination with the first aspect, the barrier region covers all regions on a first main junction layer except the first well region in the single-photon avalanche diode unit. The first main junction layer is a layer level where the first well region is located in the single-photon avalanche diode unit in the depth direction, and the barrier region has a depth greater than that of the first well region.

The barrier region covers all regions except the first well region at the layer level where the first well region is located and has a depth greater than that of the first well region, so that electron drift to the side of the main junction is avoided to prevent leakage current, the electric field convergence effect is maximized, and the PDE is improved.

In an exemplary design, in combination with the first aspect, the doping concentration of the barrier region is lower than that of the first well region.

The doping concentration of the barrier region is lower than that of the first well region, so that the barrier region does not affect the avalanche main junction.

In an exemplary design, in combination with the first aspect, the doping concentration of the hole conducting region is higher than that of the first well region.

The doping concentration of the hole conducting region is higher than that of the first well region, thereby providing an equipotential position and forming a focused electric field distribution within the main junction region. The hole conducting region facilitates hole collection and provides a low-resistance hole conducting path. In addition, interface defects caused by a deep trench isolation (DTI) structure process between single-photon avalanche diode units are pinned, thereby reducing the DCR.

In an exemplary design, in combination with the first aspect, the number of the main junctions is multiple, and the multiple main junctions are distributed in parallel in the single-photon avalanche diode unit.

The multiple main junctions distributed in parallel in the single-photon avalanche diode unit can make full use of the charge focusing principle of a smaller main junction area in a larger single-photon avalanche diode unit, maximize photo-generated charge collection and avalanche conversion efficiency, and further improve PDE and reduce DCR. The design of multiple main junctions can compress the drift distance of carriers to the avalanche main junction, and can improve time jitter.

In an exemplary design, in combination with the first aspect, the lens structure of the single-photon avalanche diode unit includes multiple microlenses. The number of the multiple microlenses and the layout of the multiple microlenses in the single-photon avalanche diode unit are set based on the number of the multiple main junctions and the layout of the multiple main junctions in the single-photon avalanche diode unit.

The multiple microlenses with a number and a distribution matched with the multiple main junctions in the single-photon avalanche diode unit can focus and collect incident light with a larger area range and a larger incident angle into the single-photon avalanche diode unit, enhance the light intensity entering the single-photon avalanche diode unit, increase absorption of the single-photon avalanche diode unit to light, and enhance PDE.

In an exemplary design, in combination with the first aspect, the single-photon avalanche diode unit further includes a first light scattering structure. The first light scattering structure is disposed between a first main junction layer of the single-photon avalanche diode unit and an electrode layer of the single-photon avalanche diode unit. The first main junction layer is a level of the first well region in the single-photon avalanche diode unit in a depth direction, and the electrode layer is a level of an electrode of the single-photon avalanche diode unit in the single-photon avalanche diode unit in the depth direction.

The first light scattering structure disposed in the single-photon avalanche diode unit can improve absorption efficiency of the single-photon avalanche diode unit to light, and enhance PDE.

In an exemplary design, in combination with the first aspect, the first light scattering structure is greater than a preset distance from the main junction.

The first light scattering structure is kept at a certain distance from the main junction, and process defect loss can be avoided to prevent DCR from increasing.

In an exemplary design, in combination with the first aspect, the single-photon avalanche diode unit further includes a metal light reflection structure. The metal light reflection structure is disposed on an outer side of an electrode layer of the single-photon avalanche diode unit and connected with an electrode of the electrode layer. The electrode layer is a level of an electrode of the single-photon avalanche diode unit in the single-photon avalanche diode unit in a depth direction. The outer side of the electrode layer is a side facing away from a first main junction layer of the single-photon avalanche diode unit, and the first main junction layer is a level of the first well region in the single-photon avalanche diode unit in the depth direction.

The metal light reflection structure is arranged on the outer layer of the single-photon avalanche diode unit, so that the light reflection effect is increased, the light absorption efficiency of the single-photon avalanche diode unit is increased, and the PDE is enhanced.

In an exemplary design, in combination with the first aspect, an area of the metal light reflection structure is greater than a preset area.

The area of the metal light reflection structure is set to be large enough, so that the light reflection efficiency is improved, the efficiency of secondary and multiple light absorptions by the single-photon avalanche diode unit is improved, and the PDE is enhanced.

In an exemplary design, in combination with the first aspect, the single-photon avalanche diode unit further includes a second light dispersion structure. The second light dispersion structure is arranged on an inner side of a lens layer of the single-photon avalanche diode unit, the lens layer is a level of a lens structure of the single-photon avalanche diode unit in a depth direction in the single-photon avalanche diode unit, the inner side of the lens layer is a side facing a first main junction layer of the single-photon avalanche diode unit, and the first main junction layer is a level of the first well region in the depth direction in the single-photon avalanche diode unit.

The second light dispersion structure is arranged in the single-photon avalanche diode unit, so that the optical absorption path and efficiency are enhanced, and the PDE is enhanced.

In an exemplary design, in combination with the first aspect, a size of the first well region is smaller than a size of a second well region, and the second well region is a well region of the main junctions that is closest to an electrode of the single-photon avalanche diode unit in a depth direction.

In a second aspect, an electronic device is provided. The electronic device has the single-photon avalanche diode unit of the electronic device in the first aspect.

The present application can achieve the following technical effects: by limiting the size of the main junction in the single-photon avalanche diode unit to a smaller size, the number of process defects can be reduced, thereby reducing the DCR, and the size of the main junction in the single-photon avalanche diode unit is limited to a smaller size range, the peripheral lateral electric field of the main junction can be weakened, the lateral breakdown voltage is improved, the main junction edge breakdown is avoided, and the DCR is further reduced; by arranging the barrier region around the first well region, the barrier region surrounds the first well region and extends outward to a hole conducting region with the same polarity as the first well region, the barrier region can prevent the electron photo-generated carriers from flowing to the side, which helps increase the collection efficiency of the photo-generated carriers, and improves the PDE, the barrier region is combined with the main junction with a smaller size to form an electric field convergence effect in the main junction region, so that the electric field strength near the main junction can be enhanced, the avalanche triggering probability is improved, and the PDE is further improved. Therefore, the PDE and the DCR can be simultaneously optimized, and the detection performance of the single-photon avalanche diode unit is improved.

### BRIEF DESCRIPTION OF DRAWINGS

In order to more clearly illustrate the technical solutions of the embodiments of the present application, the following will briefly introduce the drawings used in the description of the embodiments of the present application. Obviously, the drawings in the following description only represent some of the embodiments of the present application, and other drawings can be obtained by those skilled in the art without creative labor.
FIG. 1 is a schematic diagram of a typical structure of a back-illuminated planar structure type SPAD unit according to some embodiments of the present application;
FIG. 2 is a schematic diagram of an electron drift path of the back-illuminated planar structure type SPAD unit according to some embodiments of the present application;
FIG. 3 and FIG. 4 are schematic diagrams of structures of single-photon avalanche diode units according to some embodiments of the present application;
FIG. 5 and FIG. 6 are schematic diagrams of electron drift paths of the single-photon avalanche diode units according to some embodiments of the present application;
FIG. 7 and FIG. 8 are schematic diagrams of structures of single-photon avalanche diode units according to some embodiments of the present application;
FIG. 9 is a schematic diagram of an incident light propagation path of a single-photon avalanche diode unit containing multiple optical structures according to some embodiments of the present application; and
FIG. 10 and FIG. 11 are top views of single-photon avalanche diode units containing multiple main junctions according to some embodiments of the present application.

### DETAILED DESCRIPTION

In order to make the purpose, technical solutions and advantages of the present application clearer and more understandable, the present application is further described in detail below in combination with the drawings and embodiments. It should be understood that the specific embodiments described herein are only used to explain the present application, and are not used to limit the present application. Based on the embodiments in the present application, all other embodiments obtained by those skilled in the art without creative labor are within the protection scope of the present application.

It should be noted that, if there is no conflict, each feature in the embodiments of the present application can be combined with each other, and all within the protection scope of the present application. In addition, although the functional modules are divided in the device schematic diagram, and the logical order is shown in the flow chart, in some cases, the steps shown or described can be performed in a manner different from the module division in the device or the order in the flow chart. Furthermore, the "first", "second", "third" and the like used in the present application do not limit the data and execution order, and only distinguish the same items or similar items with basically the same function and effect.

The present application provides an improved scheme for a SPAD unit. For ease of understanding, the structure of the SPAD unit is first introduced.

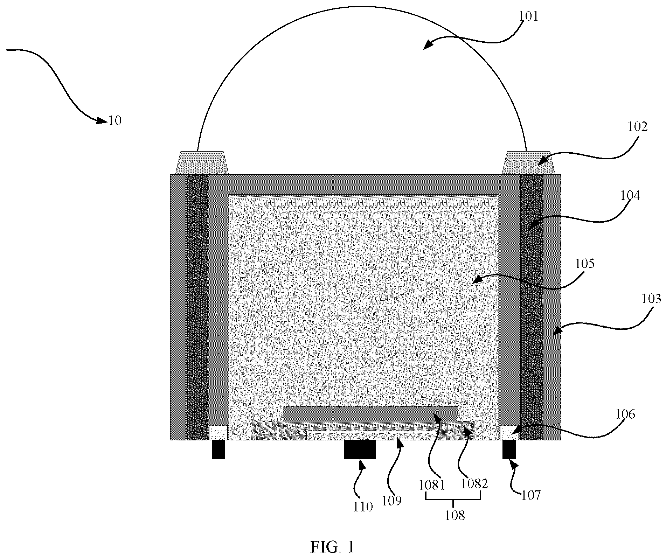

Referring to FIG. 1, which is a schematic diagram of a typical structure of a back side illumination (BSI) planar structure SPAD unit, FIG. 1 shows a schematic diagram of a vertical section structure of a SPAD unit with an N-on-P structure as a main junction structure. As shown in FIG. 1, the SPAD unit 10 includes a lens structure 101, a metal grid 102, a P-type hole conducting region 103, a DTI isolation structure 104, an epitaxial absorption region 105, a P-type heavily doped region 106, an anode electrode 107, a main junction 108, an N-type heavily doped region 109, and a cathode electrode 110. The lens structure 101 is disposed on a light incident surface of the SPAD unit 10, and incident light enters the SPAD unit 10 after converging through the lens structure 101; the metal grid 102 is disposed on both sides of the lens structure 101, and the metal grid 102 is used to increase the interaction opportunities of photons and semiconductor materials and improve the detection efficiency of photons. The incident light converges through the lens structure 101 and is incident into the epitaxial absorption region 105 of the SPAD unit 10 along the projection direction of the incident light, and is converted into electrons and holes. The P-type hole conducting region 103 surrounding the epitaxial absorption region 105 is disposed between the epitaxial absorption region 105 and the lens structure 101. The DTI isolation structure 104 connected with the metal grid 102 is disposed in the P-type hole conducting region 103 along the vertical direction, and the DTI isolation structure 104 is used to physically isolate the SPAD unit 10 from other circuit elements, reduce electrical crosstalk and optical crosstalk between the SPAD units 10, and thereby reduce noise. The P-type heavily doped region 106 is disposed on the side of the P-type hole conducting region 103 close to the epitaxial absorption region 105, and the anode electrode 107 is disposed at the position outside the P-type hole conducting region 103 and in contact with the P-type heavily doped region 106, and the anode electrode 107 is connected with the P-type heavily doped region 106. The main junction 108 is disposed in the epitaxial absorption region 105, the main junction 108 is a main junction of an N-on-P structure, the main junction 108 includes a main junction P-type well region 1081 and a main junction N-type well region 1082, the main junction N-type well region 1082 is located at a lower layer of the main junction P-type well region 1081 in a depth direction of the SPAD unit 10, the depth direction of the SPAD unit 10 is the same as the incident direction of the light, and the depth direction of the SPAD unit 10 is perpendicular to the lateral section of the SPAD unit; the N-type heavily doped region 109 is disposed in the main junction N-type well region 1082, and the cathode electrode 110 is disposed at the position outside the epitaxial absorption region 105 and in contact with the N-type heavily doped region 109, and the cathode electrode 110 is connected with the N-type heavily doped region 109.

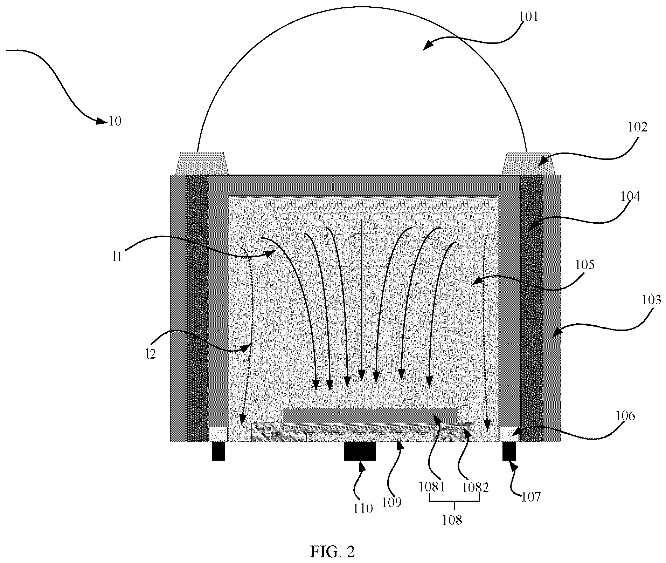

Referring to FIG. 2, after the incident light is incident into the epitaxial absorption region 105 of the SPAD unit 10 along the projection direction of the incident light, photons are absorbed and converted into electrons and holes, and the electrons migrate to a high reverse bias voltage region with the assistance of an electric field formed by the reverse bias voltage. As shown by path 11 in FIG. 2, part of the electrons reach the main junction 108 composed of the main junction P-type well region 1081 and the main junction N-type well region 1082, avalanche multiplication occurs in the main junction region to generate a larger current pulse, thereby forming an effective detection signal. As shown by path 12 in FIG. 2, another part of the electrons does not reach the main junction and flows away from the periphery of the main junction to form an invalid leakage current.

In order to improve the PDE of the SPAD unit, the area ratio of the main junction in the SPAD unit is usually increased to reduce the leakage current in the periphery of the main junction, thereby improving the collection and detection efficiency of photo-generated carriers. However, due to the limitation of the process level, a larger main junction region will bring more process defects, resulting in significant deterioration of the DCR and after-pulse indicators, and a larger main junction will also cause the increase of the lateral electric field in the periphery of the main junction and the decrease of the lateral breakdown voltage, causing the edge breakdown of the main junction and further deteriorating the DCR, especially as the SPAD unit is reduced, which will further increase the DCR. Therefore, a balance needs to be made between the PDE and the DCR, and the optimization of the PDE and the DCR cannot be achieved at the same time.

The improvement scheme of the present application aims to simultaneously optimize the PDE and the DCR, that is, to achieve high PDE while ensuring low DCR, thereby improving the detection performance of the SPAD unit.

The technical scheme of the present application is specifically described below.

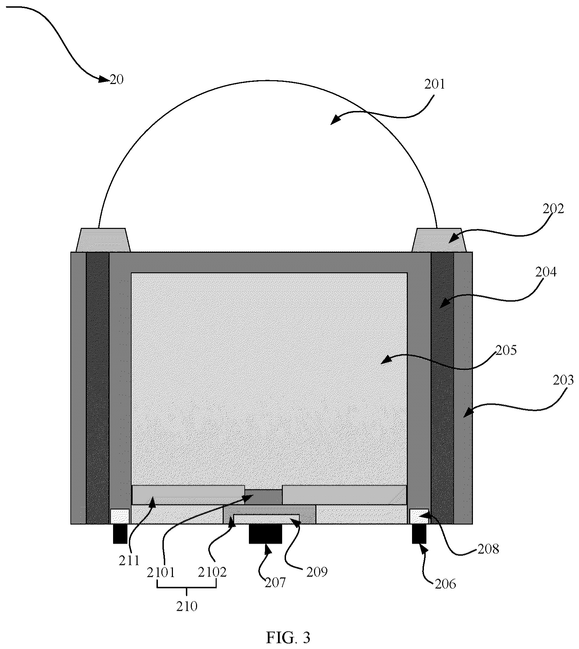

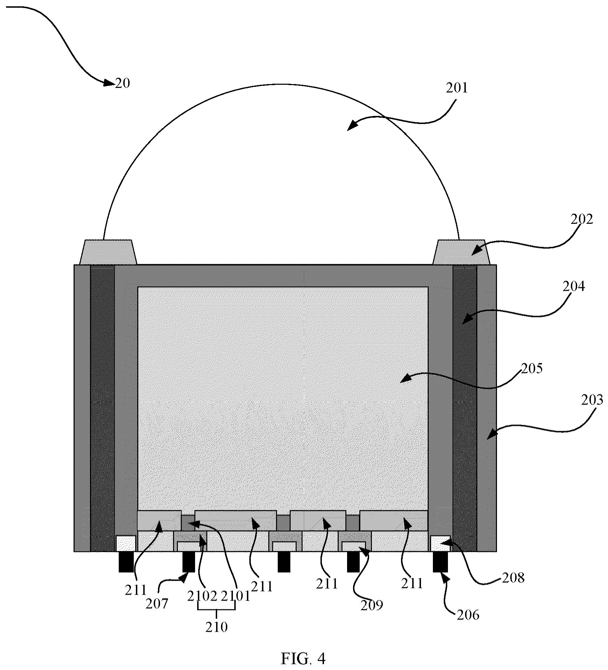

Referring to FIGS. 3 and 4, FIGS. 3 and 4 are schematic structural diagrams of a single-photon avalanche diode unit provided by an embodiment of the present application, FIG. 3 shows a vertical section schematic structural diagram of a single-photon avalanche diode unit containing a single main junction, and FIG. 4 shows a vertical section schematic structural diagram of a single-photon avalanche diode unit containing multiple main junctions.

As shown in FIGS. 3 and 4, the basic component structure of the single-photon avalanche diode unit 20 is similar to that of the BSI planar structure type SPAD unit 10 shown in FIG. 1, and can include a lens structure 201, a metal grid 202, a hole conducting region 203, a DTI isolation structure 204, an epitaxial absorption region 205, an electrode 206 and an electrode 207, and a heavily doped region 208 and a heavily doped region 209 respectively in contact with the electrode 206 and the electrode 207. The relative positional relationship and functions of the lens structure 201, the metal grid 202, the hole conducting region 203, the DTI isolation structure 204, the epitaxial absorption region 205, the electrode 206 and the electrode 207, and the heavily doped region 208 and the heavily doped region 209 respectively in contact with the electrode 206 and the electrode 207 can be referred to the description of the aforementioned FIG. 1, and will not be described herein again.

The single-photon avalanche diode unit 20 includes at least one main junction 210 and a barrier region 211 disposed in the epitaxial absorption region 205, in addition to basic constituent structures such as a lens structure and electrodes.

The main junction 210 has a size smaller than a preset size.

The barrier region 211 has the same polarity as that of a first well region 2101, the first well region 2101 being a well region in the main junction 210 that is away from the electrode of the single-photon avalanche diode unit in the depth direction.

The barrier region 211 is disposed in the same layer as the first well region 2101 in the depth direction and surrounds the first well region 2101, and the barrier region 211 extends outward to a hole conducting region 203 of the single-photon avalanche diode unit 20, the hole conducting region 203 having the same polarity as the first well region 2101.

The preset size can be set based on actual requirements and process capabilities. For example, the preset size can be set to 2 micrometers (µm).

The main junction 210 is composed of the first well region 2101 and a second well region 2102, the second well region 2102 being a well region in the main junction 210 that is close to the electrodes 206, 207 of the single-photon avalanche diode unit 20 in the depth direction.

The first well region 2101 can have a size smaller than that of the second well region 2102. The main junction 210 is composed of the first well region 2101 and the second well region 2102 can be 0.5 µm-1.5 µm away from a front surface of the single-photon avalanche diode unit 20. The front surface of the single-photon avalanche diode unit 20 refers to a surface where the electrodes of the single-photon avalanche diode unit 20 are formed. It can be understood that by setting the depth of the main junction away from the device surface, the increase in DCR caused by silicon surface defects can be minimized while the PDE of the single-photon avalanche diode unit 20 is improved, under the condition that the process conditions are met.

The main junction 210 can be an N-on-P structure or a P-on-N structure. When the main junction 210 is an N-on-P structure, the first well region 2101 is a P-type well region, the hole conducting region 203 is a P-type hole conducting region, the electrode 206 is an anode electrode, the heavily doped region 208 is a P-type heavily doped region, the second well region 2102 is an N-type well region, the electrode 207 is a cathode electrode, and the heavily doped region 209 is an N-type heavily doped region. When the main junction 210 is a P-on-N structure, the first well region 2101 is an N-type well region, the hole conducting region 203 is an N-type hole conducting region, the electrode 206 is a cathode electrode, the heavily doped region 208 is an N-type heavily doped region, the second well region 2102 is a P-type well region, the electrode 207 is an anode electrode, and the heavily doped region 209 is a P-type heavily doped region.

When the first well region 2101 is a P-type well region, the barrier region 211 is a P-type electron barrier region. When the first well region 2101 is an N-type well region, the barrier region 211 is an N-type hole barrier region.

The doping concentration of the barrier region 211 can be lower than that of the first well region 2101, and the doping concentration of the hole conducting region 203 can be higher than that of the first well region 2101. For example, when the first well region 2101 is a P-type well region, the doping concentration of the P-type well region can be on the order of 5E16-5E17 cm-3, the doping concentration of the P-type electron barrier region can be on the order of 1E16-1E17 cm-3, and the doping concentration of the P-type hole conducting region can be on the order of E16-E18 cm-3. The doping concentration of the electron barrier region being lower than that of the first well region can prevent the barrier region from affecting the avalanche main junction. The doping concentration of the hole conducting region being higher than that of the first well region can provide an equipotential position, facilitate the formation of a focused electric field distribution in the main junction region, and be used for the collection of holes and the provision of a low-resistance hole conducting loop, as well as for the pinning of interface defects caused by the process of the DTI isolation structure between single-photon avalanche diode units, thereby reducing the DCR.

The barrier region 211 can cover all regions other than the first well region 2101 on the first main junction layer in the single-photon avalanche diode unit 20, the first main junction layer being the level of the first well region 2101 in the single-photon avalanche diode unit 20 in the depth direction, and the depth of the barrier region 211 being greater than that of the first well region 2101.

The barrier region covers all regions other than the first well region at the level of the first well region and has a depth greater than that of the first well region, which can avoid the drift of electrons to the side of the main junction to form a leakage current, maximize the electric field focusing effect, and improve the PDE.

The number of main junctions 210 included in the single-photon avalanche diode unit 20 can be set based on the size of the single-photon avalanche diode unit 20. For example, in a single-photon avalanche diode unit 20 with a size less than or equal to 5 micrometers (µm), only one main junction 210 can be included due to the small size of the single-photon avalanche diode unit 20. In a single-photon avalanche diode unit 20 with a size greater than 5 µm, the design of a single main junction can cause the problem of difficult regulation of a focused electric field, and the large distance between the cathode and the anode can cause the problems of a large breakdown voltage and a large breakdown voltage temperature coefficient caused by a long charge migration path, and the single-photon avalanche diode unit 20 can include multiple main junctions 210.

When the single-photon avalanche diode unit 20 includes multiple main junctions 210, the multiple main junctions 210 can be distributed in parallel in the single-photon avalanche diode unit 20.

The parallel distribution of multiple main junctions in the single-photon avalanche diode unit can make full use of the charge focusing principle of a small main junction area in a large single-photon avalanche diode unit, maximize the collection of photo-generated charges and the avalanche conversion efficiency, and further improve the PDE and reduce the DCR. In addition, the design of multiple main junctions can compress the drift distance of carriers to the avalanche main junction, and can improve the time jitter.

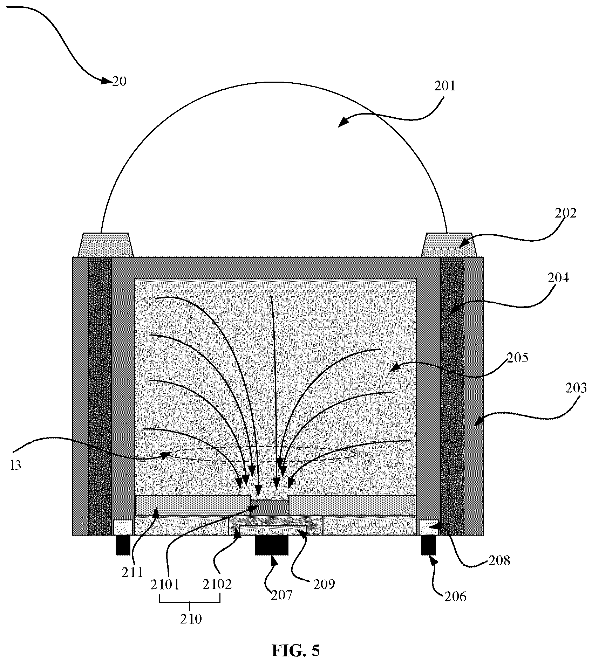

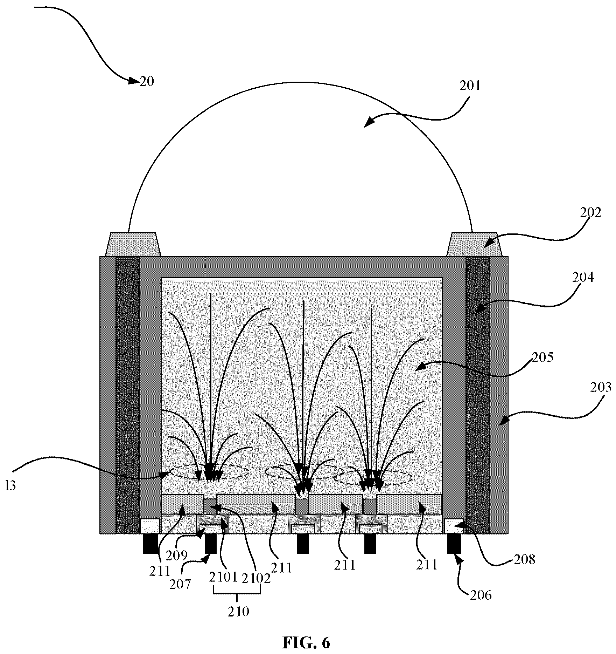

The electron drift path of the single-photon avalanche diode unit 20 provided by the application can be referred to FIG. 5 and FIG. 6. After the incident light is incident into the epitaxial absorption region 205 of the SPAD unit 20 along the projection direction of the incident light, photons are absorbed and converted into electrons and holes, and the electrons migrate to the high reverse bias voltage region with the assistance of the electric field formed by the reverse bias voltage, as shown by the path 13 in FIG. 5 and FIG. 6. Since the barrier region 211 is arranged in the single-photon avalanche diode unit 20, the barrier region helps to increase the collection efficiency of photo-generated carriers, and the main junction 210 is small, and the electric field convergence effect is formed in the main junction region when the device is reversely biased, so that the leakage current shown by the path 12 in FIG. 2 can be avoided to cause PDE loss, that is, the PDE is improved. In addition, by limiting the size of the main junction to a smaller size, the number of process defects can be reduced, and the DCR is improved. Limiting the size of the main junction in the single-photon avalanche diode unit to a smaller size range can also weaken the peripheral lateral electric field of the main junction, improve the lateral breakdown voltage, avoid the edge breakdown of the main junction, and further improve the DCR. Therefore, the single-photon avalanche diode unit 20 of the application can simultaneously optimize the PDE and the DCR, and improve the detection performance of the single-photon avalanche diode unit.

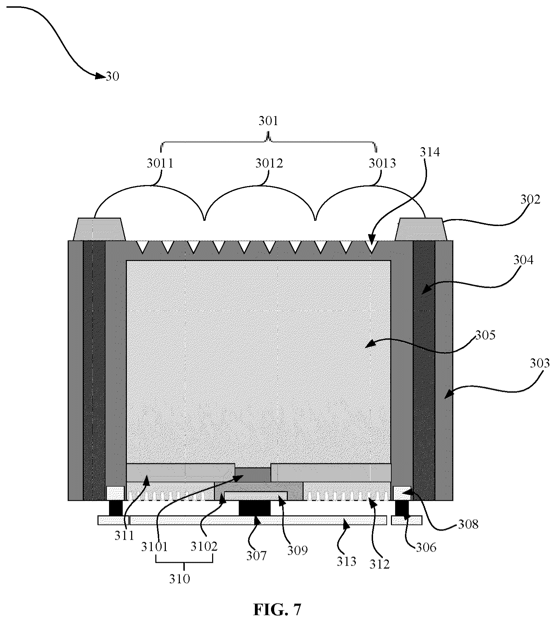

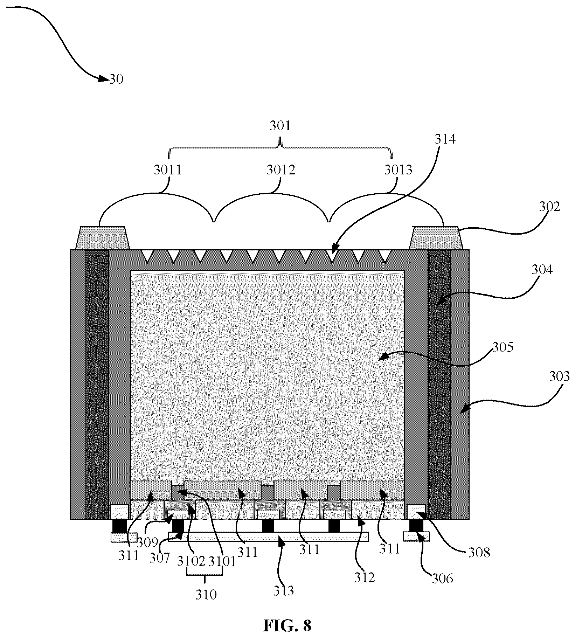

In some embodiments, an optical absorption enhancement structure can also be arranged in the single-photon avalanche diode unit to increase the distribution and optical path in the epitaxial absorption region of the single-photon avalanche diode unit, thereby improving the light absorption, conversion and utilization efficiency. Referring to FIG. 7 and FIG. 8, FIG. 7 and FIG. 8, which are structural schematic diagrams of single-photon avalanche diode units according to some embodiments of the present application. FIG. 7 shows a vertical section structural schematic diagram of another single-photon avalanche diode unit containing a single main junction, and FIG. 8 shows a vertical section structural schematic diagram of another single-photon avalanche diode unit containing multiple main junctions.

As shown in FIG. 7 and FIG. 8, the single-photon avalanche diode unit 30 includes the component structures in the single-photon avalanche diode unit 20 shown in FIG. 3 and FIG. 4, including the lens structure 301, the metal grid 302, the hole conducting region 303, the DTI isolation structure 304, the epitaxial absorption region 305, the electrode 306 and the electrode 307, the heavily doped region 308 and the heavily doped region 309 respectively contacting the electrode 306 and the electrode 307, and at least one main junction 310 and the barrier region 311 arranged in the epitaxial absorption region 305. The relative position relationship and the role of the lens structure 301, the metal grid 302, the hole conducting region 303, the DTI isolation structure 304, the epitaxial absorption region 305, the electrode 306 and the electrode 307, the heavily doped region 308 and the heavily doped region 309 respectively contacting the electrode 306 and the electrode 307, and at least one main junction 210 and the barrier region 211 arranged in the epitaxial absorption region 305 can be referred to the description of FIG. 3 and FIG. 4, and will not be described herein again.

As shown in FIG. 7 and FIG. 8, the single-photon avalanche diode unit 30 further includes a first light scattering structure 312, which is disposed between the first main junction layer of the single-photon avalanche diode unit 30 and the electrode layer of the single-photon avalanche diode unit 30. The first main junction layer of the single-photon avalanche diode unit 30 is the level at which the first well region 3101 is located in the single-photon avalanche diode unit 30 in the depth direction. The electrode layer of the single-photon avalanche diode unit 30 is the level at which the electrodes 306 and 307 of the single-photon avalanche diode unit 30 are located in the single-photon avalanche diode unit 30 in the depth direction. For the meaning of the depth direction, reference can be made to the description of FIG. 1, and details are not repeated here.

The first light scattering structure 312 can also be referred to as a front optical scattering structure of the single-photon avalanche diode unit 30, and is used for scattering and isolating incident light. In some specific designs, the first light scattering structure can be specifically disposed on the lower edge inner surface of the epitaxial absorption region 305 of the single-photon avalanche diode unit 30. The lower edge inner surface of the epitaxial absorption region 305 refers to the inner surface of the epitaxial absorption region 305 away from the lens structure 301. The first light scattering structure 312 can include some specially designed shallow trench isolation (STI) structures with light scattering capability. The STI structures can be distributed in an array on the lower edge inner surface of the epitaxial absorption region 305 of the single-photon avalanche diode unit 30. Of course, the first light scattering structure 312 can also be other forms of light scattering structures that can scatter and isolate incident light, and can have other positions and distribution manners, which are not limited in the present application.

The distance between the first light scattering structure 312 and the main junction 310 can be greater than a preset distance, which is a safety distance required to avoid process defects. Keeping a certain distance between the first light scattering structure and the main junction can avoid an increase in DCR caused by process defect loss.

By disposing the first optical light scattering structure in the single-photon avalanche diode unit, the light absorption efficiency of the single-photon avalanche diode unit can be improved, and the PDE can be enhanced.

In some designs, as shown in FIG. 7 and FIG. 8, the single-photon avalanche diode unit 30 can further include a metal light reflection structure 313, which is disposed on the outside of the electrode layer of the single-photon avalanche diode unit 30 and connected with the electrodes 306 and 307 of the electrode layer of the single-photon avalanche diode unit 30. The outside of the electrode layer of the single-photon avalanche diode unit 30 is a side away from the first main junction layer of the single-photon avalanche diode unit 30. The first main junction layer is the level at which the first well region 3101 is located in the single-photon avalanche diode unit 30 in the depth direction.

The metal light reflection structure 313 is a structure made of a metal material and capable of reflecting light, and is used for reflecting incident light.

The area of the metal light reflection structure 313 can be greater than a preset area. For example, the metal light reflection structure can cover the entire cross section of the single photon avalanche diode unit 30 to form a metal cross section layer, and the electrodes 306 and 307 are connected to the metal cross section layer through contact electrodes to form parallel equipotential. The area of the metal light reflection structure is set to be large enough, which can improve the light reflection efficiency, thereby improving the efficiency of secondary and multiple absorptions of the light by the single photon avalanche diode unit and enhancing the PDE.

The metal light reflection structure is arranged on the outer layer of the single photon avalanche diode unit, the reflection effect of the light is increased, the absorption efficiency of the single photon avalanche diode unit to the light is increased, and the PDE is enhanced.

In some possible designs, as shown in FIGS. 7 and 8, the single photon avalanche diode unit 30 further includes a second light scattering structure 314, which is arranged on the inner side of a lens layer of the single photon avalanche diode unit 30. The lens layer of the single photon avalanche diode unit 30 is a layer level of the lens structure 301 of the single photon avalanche diode unit 30 in the depth direction in the single photon avalanche diode unit 30. The inner side of the lens layer of the single photon avalanche diode unit 30 is a side facing a first main junction layer of the single photon avalanche diode unit 30. The first main junction layer is a layer level of the first well region 3101 in the depth direction in the single photon avalanche diode unit 30.

The second light scattering structure 314 can also be referred to as a backside optical scattering structure of the single photon avalanche diode unit 30, and is used for scattering incident light. In some specific designs, the second light scattering structure can be specifically arranged on an upper edge inner surface of the epitaxial absorption region 305 of the single photon avalanche diode unit 30. The upper edge inner surface of the epitaxial absorption region 305 refers to an inner surface of the epitaxial absorption region 305 close to the lens structure 301. The second light scattering structure 314 can be a backside trench structure, an IPA, or other periodic light scattering patterns. Of course, the second light scattering structure 314 can also be other forms of light scattering structures that can scatter and isolate incident light, and can have other positions and distribution manners, which are not limited herein.

The second light scattering structure is arranged in the single photon avalanche diode unit, the optical absorption path and efficiency are enhanced, and the PDE is enhanced.

In some possible designs, as shown in FIGS. 7 and 8, the lens structure 301 in the single photon avalanche diode unit 30 can include a plurality of microlenses (3011, 3012, 3013). The plurality of microlenses can be seamless multi-microlenses, that is, the plurality of lenses are in close contact with each other without gaps. The microlenses can be spherical microlenses or cylindrical microlenses, which are not limited herein.

The number of the plurality of microlenses and the layout of the plurality of microlenses in the single photon avalanche diode unit 30 can be set based on actual requirements.

When the single photon avalanche diode unit 30 only contains one main junction 301 as shown in FIG. 7, the plurality of microlenses can focus and collect the incident light in a larger area range and a larger incident angle into the single photon avalanche diode unit 30, thereby enhancing the light intensity in the single photon avalanche diode unit 30.

When the single photon avalanche diode unit 30 contains a plurality of main junctions 310 as shown in FIG. 8, the number of the plurality of microlenses and the layout of the plurality of microlenses in the single photon avalanche diode unit 30 can be set based on the number of the plurality of main junctions 310 and the layout of the plurality of main junctions 310 in the single photon avalanche diode unit 30. The plurality of microlenses can be distributed in an array. It should be understood that the number and the layout of the plurality of microlenses can also be inconsistent with the number and the layout of the plurality of main junctions 310 in the single photon avalanche diode unit 30, and the application does not limit this.

By setting the number and the distribution of the plurality of microlenses to match the plurality of main junctions in the single photon avalanche diode unit, the incident light in a larger area range and a larger incident angle can be focused and collected into the single photon avalanche diode unit, thereby enhancing the light intensity entering the single photon avalanche diode unit, increasing the absorption of the single photon avalanche diode unit to the light, and enhancing the PDE.

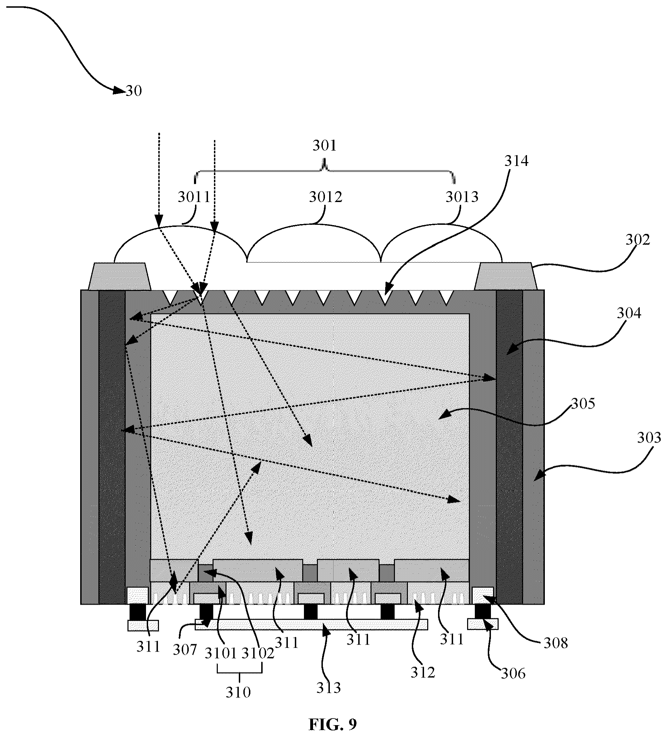

The propagation path of the incident light of the single photon avalanche diode unit 30 provided with the optical absorption enhancement structure can be referred to FIG. 9. As shown in FIG. 9, the plurality of microlenses can collect more incident light into the single photon avalanche diode unit 30, and the incident light can be fully absorbed after being scattered by the second light scattering structure 314 and the first light scattering structure 312 and reflected by the metal light reflection structure 313. By combining the optical enhancement with the electrical enhancement, the PDE can be greatly enhanced and the DCR can be greatly reduced.

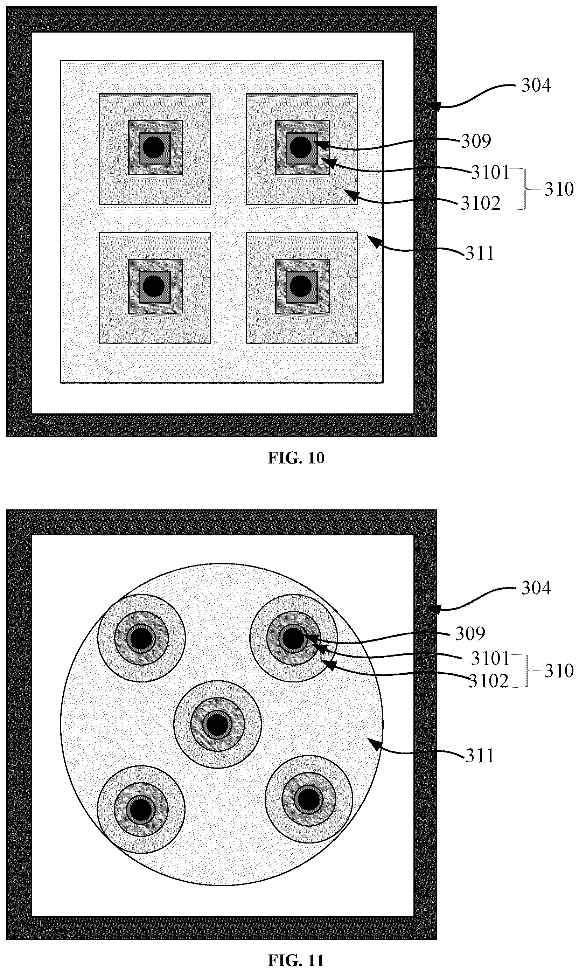

Next, please refer to FIG. 10 and FIG. 11, which are top views of the single photon avalanche diode unit containing the plurality of main junctions provided by the embodiments of the present application. FIG. 10 shows a top view of the single photon avalanche diode unit containing four square main junctions arranged in a 2x2 manner. The single photon avalanche diode shown in FIG. 10 contains four square main junctions arranged in a 2x2 manner. FIG. 11 shows a top view of the single photon avalanche diode unit containing five circular main junctions.

The single photon avalanche diode unit of the present application can be used to manufacture electronic devices, such as image sensors, laser sensors, and the like.

The present application also provides an electronic device, including an electronic device having a single photon avalanche diode unit. The single photon avalanche diode unit can be as shown in FIG. 3-FIG. 11, and reference can be made to the foregoing description of FIG. 3-FIG. 11, which will not be repeated here.

The above disclosure is only exemplary embodiments of the present application, and of course cannot be used to limit the scope of the present application, so the equivalent changes made according to the claims of the application are still within the protection scope covered by the present application

## Claims

1. A single photon avalanche diode, SPAD, unit including: one or more main junctions and a barrier region, wherein
each main junction has a size smaller than a preset size;
the barrier region has a polarity identical to a polarity of a first well region of the one or more main junctions that is furthest away from an electrode of the SPAD unit in a depth direction, and
the barrier region is disposed in the same depth level as the first well region, surrounds the first well region, and extends outwardly to a hole conducting region of the SPAD unit, wherein the hole conducting region has a polarity identical to the polarity of the first well region.

2. The SPAD unit of claim 1, wherein the barrier region covers all areas of a first main junction level above the first well region in the SPAD unit, the first main junction level being a level at the depth of the first well region in the SPAD unit, and the barrier region having a larger depth than the first well region.

3. The SPAD unit of claim 1, wherein the barrier region has a doping concentration lower than a doping concentration of the first well region.

4. The SPAD unit of claim 3, wherein the hole conducting region has a doping concentration higher than the doping concentration of the first well region.

5. The SPAD unit of claim 1, wherein a plurality of main junctions are provided and distributed in parallel within the SPAD unit.

6. The SPAD unit of claim 5, wherein a lens structure of the SPAD unit includes a plurality of microlenses, a number and a layout of the plurality of microlenses being based on a number and a layout of the plurality of main junctions in the SPAD unit.

7. The SPAD unit of any one of claims 1-6, wherein the SPAD unit further includes a first light scattering structure, wherein the first light scattering structure is disposed between a first main junction layer and an electrode layer of the SPAD unit, and wherein the first main junction layer is a layer level where the first well region is positioned in a depth direction of the SPAD unit, and the electrode layer is a layer level where an electrode of the SPAD unit is positioned in the depth direction of the SPAD unit.

8. The SPAD unit of claim 7, wherein the first light scattering structure is spaced from the main junction by more than a preset distance.

9. The SPAD unit of any one of claims 1-6, further including a metal reflective structure, wherein the metal reflective structure is disposed on the outside of an electrode layer of the SPAD unit and is connected with an electrode of the electrode layer, and wherein the electrode layer is a layer level where an electrode of the SPAD unit is positioned in a depth direction of the SPAD unit, and the outside of the electrode layer is a side of the electrode layer facing away from the first main junction layer, and the first main junction layer is a layer level where the first well region is positioned in the depth direction of the SPAD unit.

10. The SPAD unit of claim 9, wherein the metal reflective structure has an area greater than a preset area.

11. The SPAD unit of any one of claims 1-6, further including a second light scattering structure, wherein the second light scattering structure is disposed on an inner side of a lens layer of the SPAD unit, and the lens layer is a layer level where a lens structure of the SPAD unit is positioned in a depth direction of the SPAD unit, and the inner side of the lens layer is a side of the lens layer facing the first main junction layer, and the first main junction layer is a layer level where the first well region is positioned in the depth direction of the SPAD unit.

12. The SPAD unit of any one of claims 1 to 6, wherein the first well region has a smaller size than a second well region, the second well region is a well region of the main junction that is closest to an electrode of the SPAD unit in the depth direction.

13. An electronic device including an electronic component having a SPAD unit according to any one of claims 1 to 12.
